# DEMANDE DE BREVET EUROPEEN

(11) **EP 1 352 711 A1**
(43) Date de publication de la demande: **15.10.2003**
(21) Numéro de dépôt: 03364003.8
(22) Date de dépôt: 28.03.2003
(51) Int. Cl.: B24B 37/04, B24B 57/02, B24B 41/06

(54) **Machine de polissage mécanico-chimique d'une plaquette de matériau et dispositif de distribution d'abrasif équipant une telle machine**

(30) Priorité: 11.04.2002 FR 0204494
(71) Demandeur: S.O.I.Tec Silicon on Insulator Technologies, 38190 Bernin (FR)
(72) Inventeur: Metral, Frédéric, 38210 Saint-Quentin sur Isere (FR)
(74) Mandataire: Bomer, Françoise Marie

(57) **Abrégé**

L'invention concerne une machine de polissage mécanico-chimique d'une plaquette **(P)** d'un matériau, cette machine comprenant un plateau de polissage (1) rotatif, une tête de polissage (4) comprenant une partie non rotative (42) et une partie rotative (40, 41) et des moyens (5) de distribution d'un abrasif **(A)** à la surface dudit plateau de polissage (1).

Cette machine est remarquable en ce que les moyens (5) de distribution de l'abrasif **(A)** comprennent un anneau creux (50) de distribution d'abrasif, muni de moyens (51) d'amenée de l'abrasif, d'une pluralité d'orifices de distribution d'abrasif répartis sur sa face inférieure (502) et de moyens de fixation (420, 520, 52) permettant de le rendre solidaire de ladite partie non rotative (42) de la tête de polissage (4), cet anneau (50) étant disposé autour de ladite partie rotative (40, 41), dans un plan sensiblement parallèle au plan dudit plateau de polissage (1) mais écarté de celui-ci.

Application au polissage de plaquettes **(P)** de matériau semi-conducteur.

## Description

La présente invention concerne une machine de polissage mécanico-chimique d'une plaquette d'un matériau destiné à la fabrication de substrats pour l'optique, l'optoélectronique ou l'électronique, notamment un matériau semi-conducteur.

L'invention concerne également un dispositif de distribution d'abrasif équipant une telle machine.

Les plaquettes précitées sont utilisées dans la fabrication de circuits intégrés. Au cours de cette fabrication, on utilise des techniques de report et de collage direct de couches issues d'une première plaquette constituant un substrat source, sur une seconde plaquette constituant un support. Ces techniques de collage direct sont très exigeantes en terme d'absence de rugosité et de planéité des surfaces à mettre en contact et nécessitent donc un polissage parfait des surfaces des plaquettes.

Par ailleurs, dans certains procédés, comme par exemple celui connu sous la dénomination "Smart Cut" (marque déposée), on procède à de multiples reports de couches à partir d'une plaquette et on retouche la surface de cette plaquette avant chaque nouveau prélèvement d'une couche. Cette retouche est également effectuée par polissage.

Dans les deux cas précités, ce polissage est effectué grâce à une machine de polissage mécanico-chimique.

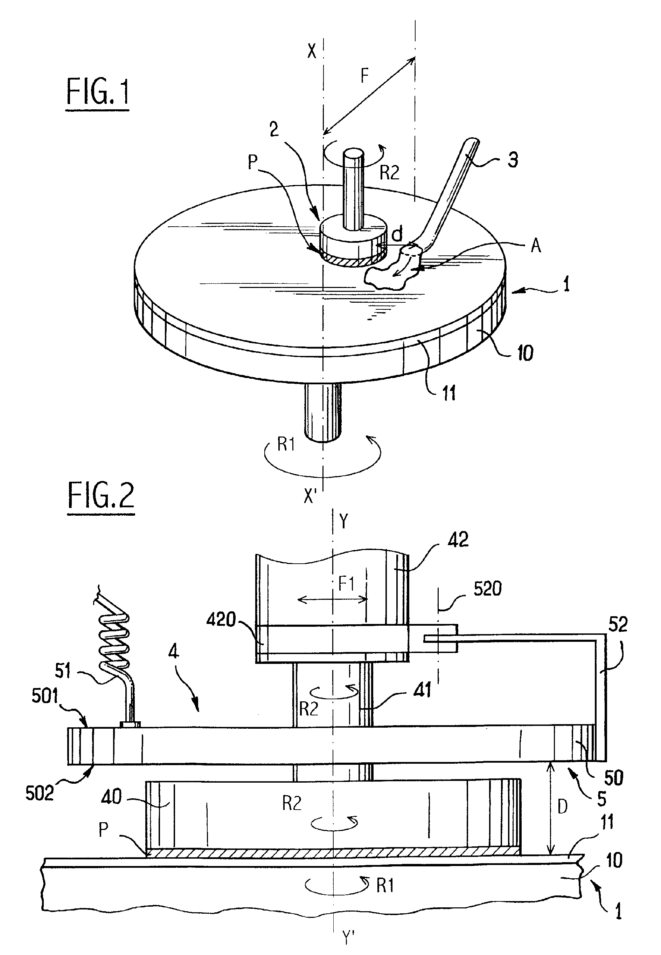

Une telle machine est connue de l'homme du métier et comprend généralement comme illustré schématiquement sur la figure 1 jointe : un plateau de polissage 1, une tête de polissage 2 et un ou plusieurs organes fixes de distribution 3 d'un abrasif **A** se présentant sous une forme pâteuse ou liquide. Cet abrasif est par exemple de la silice colloïdale.

Le plateau de polissage 1 comprend un disque 10 entraîné en rotation autour d'un axe vertical **X-X'**, ce mouvement de rotation étant symbolisé par la flèche **R1**.

Le disque 10 est recouvert d'un tissu de polissage 11.

La tête de polissage 2 est également rotative (flèche **R2**), elle tourne généralement dans le même sens que le plateau 1. Elle est animée en outre d'un mouvement d'oscillation ou de va-et-vient, symbolisé par la flèche **F**. Ce mouvement d'oscillation s'effectue généralement selon un rayon dudit plateau 1 et de façon à déplacer ladite tête de polissage 2 dans un plan parallèle à celui du plateau 1.

Cette tête de polissage 2 présente des moyens de fixation (non représentés sur la figure) d'une plaquette **P** à polir.

Ces moyens de fixation comprennent en général un insert (ou une membrane) en forme de disque, réalisé dans un matériau ayant un coefficient d'adhérence élevé, cet insert étant entouré d'un anneau de retenue solidaire de la tête de polissage 2. L'insert maintien la plaquette à polir **P** par l'une de ses faces, dite "face arrière" et l'anneau de retenue la maintient par ses bords.

Ces moyens de fixation permettent d'entraîner en rotation ladite plaquette **P** conjointement avec la tête de polissage 2. L'anneau de retenue bloque la plaquette **P** en translation et empêche que celle-ci ne soit entraînée par la vitesse linéaire produite par la rotation du plateau 1.

En outre, la tête de polissage 2 permet de presser la face avant de cette plaquette **P** contre le tissu de polissage 11 du plateau 1.

La face avant de la plaquette **P** est donc polie grâce au mouvement relatif de la tête de polissage 2 par rapport au plateau 1, c'est à dire par une action mécanique, mais également grâce à la présence du produit chimique que constitue l'abrasif **A**, d'où l'expression de machine de polissage "mécanico-chimique".

Le fait que la tête de polissage 2 soit animée d'un mouvement d'oscillation **F** et que le plateau de polissage 1 soit rotatif permet d'obtenir une usure homogène du tissu de polissage 11 sur toute la surface de celui-ci.

Cette oscillation de la tête de polissage 2 entraîne également une variation de la distance **d** entre cette tête et l'organe de distribution d'abrasif 3 qui constitue un point fixe et qui se trouve sensiblement au milieu du rayon du plateau 1. Ceci est une source de non-reproductibilité du procédé de polissage.

En outre, lorsque cette distance **d** est importante, c'est à dire lorsque la tête de polissage 2 est écartée au maximum du point de distribution 3, parce qu'elle se trouve soit au centre, soit au bord du plateau 1, on observe une dispersion et donc une perte importante de l'abrasif **A**.

On connaît déjà d'après le document EP 1 037 262, une machine de polissage mécanico-chimique d'une plaquette, similaire à celle qui vient d'être décrite.

Dans cette machine, la tête de polissage est entourée d'un anneau de retenue dont la face en contact avec le plateau de polissage présente une gorge annulaire, en forme de U renversé. Cette gorge combinée à la surface du plateau de polissage située en regard forme une "poche" pour une bouillie abrasive, celle-ci étant amenée dans ladite gorge en U depuis une source d'alimentation extérieure, par l'intermédiaire d'une tubulure. Cette bouillie abrasive est distribuée sur le plateau de polissage et se glisse entre celui-ci et la face à polir de la plaquette.

Toutefois, cette machine de polissage présente de nombreux inconvénients.

Tout d'abord, comme l'anneau de retenue est entraîné en rotation avec la tête de polissage, la tubulure qui amène l'abrasif à l'intérieur de cet anneau a tendance à s'enrouler autour de cette tête ce qui nuit grandement au fonctionnement de celle-ci.

En outre, l'anneau de retenue est une pièce d'usure se trouvant en contact direct avec le tissu recouvrant le plateau de polissage et il doit donc être remplacé régulièrement. Or, l'usinage de la gorge en U rend sa structure plus complexe. De ce fait, l'anneau de retenue devient plus coûteux à fabriquer et son remplacement augmente également le coût global de fonctionnement de la machine de polissage.

Enfin, l'abrasif est distribué par une gorge en U sur la totalité de la périphérie de l'anneau de retenue et il n'existe pas de moyens de limiter sa distribution en certains points localisés.

On connaît également d'après le document US-6 030 487 une tête de polissage mécanico-chimique d'une plaquette munie d'un dispositif additionnel permettant la distribution simultanée d'une bouillie abrasive et d'un fluide visant à remettre à l'état neuf, la surface d'un plateau de polissage situé en regard.

Un tel dispositif additionnel comprend quatre branches dont chacune est traversée par un ou plusieurs canaux permettant d'amener les fluides précités jusqu'à un élément en quart de cercle ou jupe, percé également de plusieurs canaux et orifices de distribution.

Ce dispositif additionnel de distribution de l'abrasif présente l'inconvénient d'être solidaire de la tête de polissage rotative, de sorte qu'il est également entraîné en rotation et que l'abrasif est distribué de façon irrégulière ou est projeté vers l'extérieur de la plaquette. Une partie de l'abrasif n'est donc pas utilisée pour le polissage ce qui est désavantageux d'un point de vue économique.

On connaît enfin d'après le document WO-01/91974 un dispositif de distribution d'une bouillie abrasive utilisée dans une machine de polissage de plaquettes. Ce dispositif comprend un support de plaquette de forme annulaire présentant une pluralité de canaux verticaux de distribution de l'abrasif débouchant au niveau de sa face inférieure plane.

Ce dispositif présente l'inconvénient que les canaux sont usinés directement dans le support de plaquette alors que celui-ci constitue une pièce d'usure qui doit être remplacée régulièrement pour maintenir les performances de la machine de polissage. Ce support de plaquette de structure plus complexe qu'un support classique est donc plus coûteux et son remplacement l'est également.

La présente invention a pour but de remédier aux inconvénients précités de l'état de la technique.

A cet effet, l'invention concerne une machine de polissage mécanico-chimique d'une plaquette d'un matériau, notamment d'un matériau semi-conducteur, destinée à la fabrication de substrats pour l'optique, l'optoélectronique ou l'électronique, comprenant :
- un plateau de polissage animé d'un mouvement de rotation sur lui-même,
- une tête de polissage mobile par rapport audit plateau de polissage et comprenant une partie non rotative et une partie rotative munie de moyens de fixation de ladite plaquette à polir, cette partie rotative permettant d'entraîner en rotation ladite plaquette tout en maintenant l'une des ses faces au contact dudit plateau de polissage,
- des moyens de distribution d'un abrasif à la surface dudit plateau de polissage.

Conformément à l'invention, les moyens de distribution de l'abrasif comprennent un tube fermé sur lui-même de façon à former un anneau, dit "anneau de distribution d'abrasif', relié à une source d'alimentation en abrasif et muni d'une pluralité d'orifices de distribution d'abrasif, cet anneau de distribution d'abrasif comprenant des moyens de fixation permettant de le rendre solidaire de ladite partie non rotative de la tête de polissage et étant disposé autour de ladite partie rotative, dans un plan sensiblement parallèle au plan dudit plateau de polissage mais écarté de celui-ci, lesdits orifices de distribution débouchant en regard dudit plateau de polissage.

Selon d'autres caractéristiques avantageuses et non limitatives de l'invention, prises seules ou en combinaison :
- ladite tête de polissage est animée d'un mouvement de va et vient dans un plan parallèle au plan dudit plateau de polissage ;
- tous les orifices de distribution d'abrasif sont équidistants avec le bord de la plaquette à polir ;
- les orifices de distribution d'abrasif sont susceptibles d'être obturés par des bouchons.

L'invention concerne également un dispositif de distribution d'un abrasif à la surface du plateau de polissage 1 d'une machine de polissage mécanico-chimique d'une plaquette **P**.

Ce dispositif est remarquable en ce qu'il comprend un tube fermé sur lui-même de façon à former un anneau, dit "anneau de distribution d'abrasif', cet anneau étant muni de moyens d'amenée de l'abrasif depuis une source d'alimentation, d'une pluralité d'orifices de distribution d'abrasif, répartis sur sa face inférieure et de moyens de fixation permettant de le rendre solidaire d'une partie non rotative de la tête de polissage équipant la machine de polissage mécanico-chimique.

D'autres caractéristiques et avantages de l'invention apparaîtront à la lecture de la description suivante d'un mode de réalisation préféré de l'invention, donné à titre d'exemple non limitatif. Cette description est faite en référence aux dessins annexés dans lesquels :
- la figure 1 est une vue schématique en perspective d'une machine de polissage mécanico-chimique de l'art antérieur ;
- la figure 2 est une vue de côté, partielle, de la machine de polissage mécanico-chimique selon l'invention,
- la figure 3 est une vue agrandie de l'anneau de distribution d'abrasif de l'invention, prise selon un plan de coupe diamétral vertical, et
- la figure 4 est une vue en perspective et de dessous de l'anneau de distribution d'abrasif selon l'invention.

En se reportant à la figure 2, on peut voir que la machine de polissage "mécanico-chimique" selon l'invention comprend un plateau de polissage 1, identique à celui décrit précédemment pour l'état de la technique illustré sur la figure 1 et dont les parties constitutives portent donc les mêmes références numériques.

La tête de polissage porte la référence générale 4.

Cette tête de polissage 4 comprend une partie rigide 40 ayant la forme générale d'un disque, entraînée en rotation par un moteur (non représenté sur les figures), par l'intermédiaire d'un arbre d'entraînement 41. La rotation s'effectue autour d'un axe vertical **Y-Y'**.

La partie rotative 40 est munie de moyens de fixation d'une plaquette **P** à polir, ces moyens permettant d'entraîner en rotation ladite plaquette. Ces moyens sont par exemple un anneau de retenue et un insert semblables à ceux décrits précédemment pour la tête de polissage connue de l'état de la technique. D'autres moyens de fixation connus de l'homme du métier peuvent également être utilisés.

La tête de polissage 4 comprend également des moyens non représentés sur les figures permettant de plaquer plus ou moins fortement la face à polir de la plaquette **P** contre le plateau de polissage 1 ou plus précisément contre le tissu de polissage 11 recouvrant celle-ci. Généralement, la pression est appliquée soit directement sur la tête de polissage au moyen d'un vérin, soit sur la plaquette par l'intermédiaire d'une membrane, telle qu'une chambre à air.

L'arbre 41 est monté à l'intérieur d'un manchon 42 lui-même relié à des organes de support et d'entraînement de la tête de polissage 4, ces organes n'étant pas représentés sur les figures.

Ce manchon 42 n'est pas mobile en rotation et peut uniquement se déplacer selon un mouvement d'oscillation ou de va-et-vient (flèche **F1**). De façon avantageuse, ce mouvement s'effectue le long d'un rayon du plateau de polissage 1. L'arbre 41 et le manchon 42 sont avantageusement coaxiaux.

Ce type de tête de polissage est connu de l'homme du métier et ne sera pas décrit davantage.

Selon l'invention, cette tête de polissage 4 est équipée de moyens 5 de distribution d'abrasif.

Ces moyens 5 comprennent un tube 50, recourbé pour être fermé sur lui-même, de sorte qu'il présente en vue de dessus la forme générale d'un anneau dénommé ultérieurement "anneau de distribution d'abrasif'.

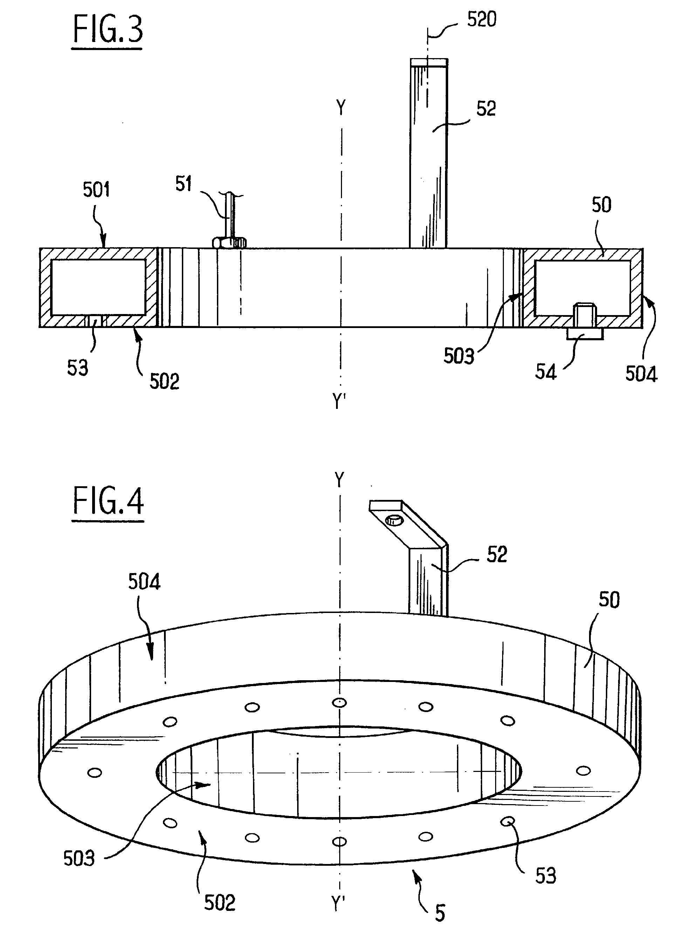

En se reportant à la figure 3, on constate que cet anneau 50 présente un axe de révolution **Y-Y'** qui se confond avec l'axe **Y-Y'** de la tête de polissage 4 lorsqu'il est fixé sur le manchon non rotatif 42.

De préférence, cet anneau 50 possède une section rectangulaire selon un plan de coupe vertical passant par l'axe **Y-Y'**.

Il présente de ce fait une face supérieure 501 et une face inférieure 502 planes et des faces intérieure 503 et extérieure 504 cylindriques.

De façon avantageuse, cet anneau de distribution 50 est réalisé dans une résine thermoplastique du type fluoropolymère, (par exemple en résine perfluoroalkoxy PFA).

Comme cela apparaît mieux sur la figure 2, cet anneau 50 est relié à une source d'alimentation en abrasif (non représentée), par l'intermédiaire de moyens d'amenée 51 de l'abrasif, tels une tubulure. Cette tubulure 51 est fixée sur la face supérieure 501 de l'anneau 50 et débouche au niveau d'un orifice (non représenté) ménagé sur cette face 501.

L'abrasif est amené sous pression ou au contraire par écoulement simple en fonction de sa viscosité.

Par ailleurs, l'anneau de distribution 50 possède une patte de fixation 52 soudée par exemple sur sa face extérieure 504. Cette patte de fixation 52 est fixée à un collier 420 monté à la base du manchon 42 de la tête de polissage 4, par tout moyen de fixation approprié, tel qu'une vis. Seul l'axe de fixation référencé 520 a été représenté sur la figure 2.

En outre, comme on peut le voir sur les figures 3 et 4, l'anneau de distribution 50 présente sur sa face inférieure 502, une série d'orifices 53, dénommés "orifices de distribution d'abrasif' et répartis uniformément.

A titre d'exemple, on peut prévoir douze orifices 53 répartis angulairement tous les 30°.

De préférence, tous ces orifices 53 sont équidistants de l'axe **Y-Y'** et donc de la tête de polissage 4 et du bord circulaire de la plaquette à polir **P** qui est fixée sur celle-ci. Ils débouchent en regard du tissu 11 du plateau de polissage 1 lorsque l'anneau 50 est monté sur le manchon 42 de la tête de polissage 4.

Ces orifices de distribution 53 sont susceptibles d'être obturés par des bouchons 54. Ces bouchons 54 peuvent par exemple être vissés à l'intérieur des orifices 53 qui, dans ce cas, sont munis d'un filetage approprié.

Ainsi, il est possible de sélectionner le nombre d'orifices de distribution 53 qui sont ouverts et leur répartition dans l'espace. Il est ainsi possible de distribuer des quantités variables d'abrasif en fonction par exemple de la nature du matériau constituant la plaquette **P** à polir.

L'anneau de distribution 50 est fixé sur le manchon 42 de façon que sa face inférieure plane 502 s'étende dans un plan parallèle ou sensiblement parallèle à celui du plateau de polissage 1, mais écarté au-dessus de celui-ci. En d'autres termes et comme illustré sur la figure 2, la face inférieure 502 de l'anneau de distribution 50 s'étend à une distance **D** du tissu 11 du plateau de polissage 1, cette distance **D** pouvant varier par exemple de 5 à 10 cm. L'anneau de distribution 50 n'est donc pas en contact avec le tissu de polissage 11 et de ce fait ne s'use pas.

Le fonctionnement de la machine de polissage mécanico-chimique selon l'invention va maintenant être décrit en faisant référence aux figures 2 à 4.

La plaquette **P** à polir est fixée sur la partie rotative 40 de la tête de polissage 4. Cette partie 40 est entraînée en rotation, ainsi que le plateau de polissage 1. Simultanément, l'abrasif liquide est amené, via la tubulure 51, à l'intérieur de l'anneau 50 où il se répartit uniformément et d'où il s'écoule par l'intermédiaire des orifices de distribution 53 en direction du tissu de polissage 11.

Le dispositif selon l'invention permet un gain en stabilité de la vitesse d'enlèvement du matériau de la plaquette **P**. Le procédé de polissage est donc plus uniforme, reproductible, et entraîne une diminution de la consommation d'abrasif.

La distribution homogène d'abrasif permet également une réduction des frottements de la tête de polissage 4 sur le tissu 11 en limitant l'usure de ce dernier.

L'anneau 50 de distribution d'abrasif selon l'invention présente une structure simple, il est donc peu coûteux à fabriquer. Il est amovible et peut être monté sélectivement sur une tête de polissage existante, sans qu'il soit nécessaire de modifier la structure de celle-ci.

## Revendications

1. Machine de polissage mécanico-chimique d'une plaquette (**P**) d'un matériau, notamment d'un matériau semi-conducteur, destinée à la fabrication de substrats pour l'optique, l'optoélectronique ou l'électronique, comprenant :
- un plateau de polissage (1) animé d'un mouvement de rotation sur lui-même,
- une tête de polissage (4) mobile par rapport audit plateau de polissage (1) et comprenant une partie non rotative (42) et une partie rotative (40, 41) munie de moyens de fixation de ladite plaquette à polir (**P**), cette partie rotative (40, 41) permettant d'entraîner en rotation ladite plaquette (**P**) tout en maintenant l'une des ses faces au contact dudit plateau de polissage (1),
- des moyens (5) de distribution d'un abrasif (**A**) à la surface dudit plateau de polissage (1),
**caractérisée en ce que** les moyens (5) de distribution de l'abrasif (**A**) comprennent un tube fermé sur lui-même de façon à former un anneau (50), dit "anneau de distribution d'abrasif', relié à une source d'alimentation en abrasif (**A**) et muni d'une pluralité d'orifices (53) de distribution d'abrasif, cet anneau (50) de distribution d'abrasif comprenant des moyens de fixation (420, 520, 52) permettant de le rendre solidaire de ladite partie non rotative (42) de la tête de polissage (4) et étant disposé autour de ladite partie rotative (40, 41), dans un plan sensiblement parallèle au plan dudit plateau de polissage (1) mais écarté de celui-ci, lesdits orifices de distribution (53) débouchant en regard dudit plateau de polissage (1).

2. Machine de polissage mécanico-chimique selon la revendication 1, **caractérisée en ce que** ladite tête de polissage (4) est animée d'un mouvement de va et vient dans un plan parallèle au plan dudit plateau de polissage (1).

3. Machine de polissage mécanico-chimique selon la revendication 1 ou 2, **caractérisée en ce que** tous les orifices (53) de distribution d'abrasif sont équidistants avec le bord de la plaquette à polir (**P**).

4. Machine de polissage mécanico-chimique selon l'une quelconque des revendications précédentes, **caractérisée en ce que** les orifices (53) de distribution d'abrasif sont susceptibles d'être obturés par des bouchons (54).

5. Dispositif de distribution d'un abrasif (**A**) à la surface du plateau de polissage (1) d'une machine de polissage mécanico-chimique d'une plaquette (**P**), **caractérisé en ce qu'**il comprend un tube fermé sur lui-même de façon à former un anneau (50), dit "anneau de distribution d'abrasif', cet anneau (50) étant muni de moyens (51) d'amenée de l'abrasif (**A**) depuis une source d'alimentation, d'une pluralité d'orifices (53) de distribution d'abrasif, répartis sur sa face inférieure (502) et de moyens de fixation (520, 52) permettant de le rendre solidaire d'une partie non rotative (42) de la tête de polissage (4) équipant ladite machine de polissage mécanico-chimique.
